(19) Europäisches Patentamt

European Patent Office

Office européen des brevets

(11) **EP 1 401 108 A1**

(12) **EUROPEAN PATENT APPLICATION**

(43) Date of publication:
24.03.2004 Bulletin 2004/13

(51) Int Cl.⁷: **H03M 13/29**, H04L 1/00

(21) Application number: 02292244.7

(22) Date of filing: **12.09.2002**

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(71) Applicants:
 • STMicroelectronics N.V.
 **1077 XX Amsterdam (NL)**
 • STMicroelectronics S.A.
 **92120 Montrouge (FR)**

(72) Inventors:
 • **Berens, Friedbert**
 **1202 Geneva (CH)**

 • **Thul, Michael J.**
 **67655 Kaiserslautern (DE)**
 • **Gilbert, Frank**
 **67655 Kaiserslautern (DE)**
 • **Wehn, Norbert**
 **66851 Queidersbach (DE)**

(74) Representative: **Zapalowicz, Francis**
 **Bureau D.A. Casalonga-Josse,**
 **Paul-Heyse-Strasse 33**
 **80336 München (DE)**

(54) **Electronic device avoiding write access conflicts in interleaving, in particular optimized concurrent interleaving architecture for high throughput turbo-decoding**

(57) The electronic device comprises a source memory means partitioned in N elementary source memories for storing a sequence of input data, processing means (MAP1) clocked by a clock signal and having N outputs for producing per cycle of the clock signal N data respectively associated to N input data respectively stored in the N elementary source memories at relative source addresses, N single port target memories (TMi), N interleaving tables (ILTi) containing for each relative source address the number of one target memory and the corresponding relative target address therein, N cells (CLi) connected in a ring structure, each cell being further connected between one output of the processing means, one interleaving table, and the port of one target memory, each cell being adapted to receive data from said output of the processing means and from its two neighbouring cells or to write at least some of these received data sequentially in the associated target memory, in accordance with the contents of said interleaving tables.

FIG.4

EP 1 401 108 A1

**Description**

The invention relates in general to avoiding write access conflicts in interleaving or deinterleaving, in particular for high throughput turbo-decoding.

An application of the invention is directed in general to the field of wireless communication systems, and more particularly to the CDMA systems such as the different CDMA based mobile radio systems like CDMA 2000, WCDMA (Wide Band CDMA) or the IS-95 standard.

Turbo-codes, introduced in 1993 are part of today's communication standards due to their outstanding forward error correction performance. They consist of concatenated component codes that work on the same block of information bits, separated by interleavers. The component codes are decoded individually. Key to the performance of Turbo-Codes is the iterative exchange of information between the component decoders.

The information exchanged iteratively represents the likehood of the received bit $k$ to have been sent either as $d_k = 0$ or $d_k = 1$. The decision is represented by the sign of the *Log-Likehood-Ratio* $(\text{LLR}(d_k) = \log \frac{P(d_k=1)}{P(d_k=0)}$, the confidence in this decision by its magnitude. From now on the information exchanged will simply be referred to as LLR.

Interleaving is scrambling the processing order to break up neighbourhood-relations. It is essential for the performance of Turbo-Codes. The LLR produced at position $k$, denoted as $\text{LLR}(d_k)$, is written to position interleaved $(k)$ in the RAM :

$$\text{LLR}_{\text{prod}}(d_k) \rightarrow \text{LLR}_{\text{RAM}} (d_{\text{interleaved}(k)}).$$

The interleaver and deinterleaver tables contain one-to-one mappings of source addresses to target addresses. Table 1 shows an example for reordering six LLRs to perform interleaving.

Table 1.

| Interleaver and Deinterleaver Tables for six LLRs. | | | |
|---|---|---|---|
| Address | Interleaved | Address | Deinterleaved |
| 1 | 3 | 1 | 6 |
| 2 | 6 | 2 | 4 |
| 3 | 5 | 3 | 1 |
| 4 | 2 | 4 | 5 |
| 5 | 4 | 5 | 3 |
| 6 | 1 | 6 | 2 |

Deinterleaving brings them into the original sequence again. (A 3GPP compliant table, for example, would contain up to 5114 entries).

One LLR has to be read for every LLR produced. Is only one LLR produced per time-step, interleaving can be performed on the fly through indirect addressing. However, high-throughput applications demand parallel architectures that produce more than one LLR per time-step. Thus, multiple LLRs have to be read and written concurrently. Let the number of LLRs read and written be denoted as N.

In a 0.20μm technology a single producer can achieve a maximum throughput of about 7 Mbit/s assuming 10 iterations. For 100 M bit/s, a reasonable assumption for future communication systems, N = 16 producers would be necessary requiring 16-port RAMS. But the use of N-port RAMs to solve access conflicts is, in general, infeasible.

Read access conflicts can be avoided by using N individual memories. Write access conflicts can not be avoided that easily : the positions where the produced LLRs have to be stored at depend on the interleaver. For arbitrary interleavers the target memory, the RAM each LLR has to go to, is not known at design time. At each time-step and for each RAM, the number of LLRs to be stored can vary from 0 to N. The resulting concurrent accesses to the same single port memory are the real bottleneck in high throughput Turbo-Decoding.

The problem is best illustrated by taking the interleaver table of Table 1 for two concurrently produced LLRs and assigning its addresses to two individual RAMS. Table 2 shows the interleaver table entries together with the associated RAMs and relative addresses. (From now on, only the interleaver is mentioned. Of course, the same concepts apply to the deinterleaver as well).

Table 2.

| Interleaver Table with according RAMs. | | | | | |
|---|---|---|---|---|---|
| source RAM | relative Address | Address | Interleaved | target RAM | relative Address |
| ⇒ **1** | **1** | **1** | **3** | **1** | **3** |
| 1 | 2 | 2 | 6 | 2 | 3 |
| 1 | 3 | 3 | 5 | 2 | 2 |
| ⇒ **2** | **1** | **4** | **2** | **1** | **2** |
| 2 | 2 | 5 | 4 | 2 | 1 |
| 2 | 3 | 6 | 1 | 1 | 1 |

The number of write accesses can be determined from the interleaver tables and the producing scheme : assuming that the two LLRs are produced in order of ascending relative addresses (i.e. in the first time-step at the absolute addresses 1 and 4) and interleaving is performed according to Table 2, Table 3 shows the resulting write accesses.

Table3.

| Write Accesses to LLR RAMs | | |
|---|---|---|
| Time-step | Write Accesses to RAM 1 | Write Accesses to RAM 2 |
| 1 | 2 | 0 |
| 2 | 0 | 2 |
| 3 | 1 | 1 |

In the first time-step, for example, one LLR is read from source RAM1 (Addr. 1) and written to target RAM1 (Addr. 3). The other one is read concurrently from source RAM2 (Addr. 1) and written to target RAM1 (Addr. 2), which results in two concurrent write accesses for target RAM1.

In [A. Giuletti, L. Van Der Perre, M. Strum. *Parallel turbo coding interleavers : avoiding collisions in accesses to storage elements.* IEEE Electronics Letters Vol. 38 N°5, Feb. 2002], a dedicated interleaving scheme for each given architecture and block-size is derived circumventing the arising access problems. It, however, does not allow for pre-defined interleavers, as for example in a standard like 3GPP, nor for arbitrary block-lengths or degrees of parallelization.

Other approaches use one fixed interleaver realized through wired connections between component decoders.

Another architecture capable of performing concurrent interleaving, has been presented in ISCAS'02 [M.J. Thul, N. Wehn, and L.P. Rao. Enabling High-Speed Turbo-Decoding Through Concurrent Interleaving. In *Proc. 2002 IEEE International Symposium on Circuits and Systems (ISCAS'02),* Phoenix, Arizona, USA, May 2002.]

This basic architecture is based on a single LLR distributor to determine the target RAM and address for all the N incoming data. N associated data sets made up of incoming data and local addresses are formed. An additional "relevant-or-not" signal is given to each buffer for each data set.

Every buffer thus must have access to all data sets. From all the sets each buffer selects those which are aimed at its local target RAM. A tree-like structure is built with the LLR distributor as root and buffers associated with target RAMs as leaves.

For large N, the critical path of this architecture is in the LLR distributor and increases with increasing N.

Moreover, the buffers themselves must be capable of storing multiple inputs in one cycle. Such buffers have been developed, but their intrinsic complexity grows exponentially with the number of inputs. The number of registers in each buffer has a minor role. An optimization based on two stages of buffers has also been presented in ISCAS'02. This limits the number of inputs per buffer.

The interconnect problem, however, is still critical in a multistage approach : the LLR distributor spans the whole chip. Design of such a far spread component is a challenge hard to meet using current design methodologies. Moreover, as stated above, each buffer must be connected to the LLR distributor through N data sets and the corresponding validity signals. This leads to extensive top level routing. Thus this architecture has strong negative interconnect implications in deep-submicron technologies.

The main communication basically takes place on a shared medium with very high load, making each data transfer an expensive broadcast. Such broadcasts have been identified as performance and power bottleneck.

The invention counteracts the problems of distributed logic and broadcasted communication by designing a new concurrent interleaving architecture based on point-to-point interconnected nodes.

One aim of the invention is to resolve the write access conflicts without increasing the overall latency. Further, any arbitrary number of soft-values produced can be handled, and the architecture can be distributed to smoothly fit into the whole decoder design.

As claimed, the invention proposes an electronic device, comprising

a source memory means partitioned in N elementary source memories for storing a sequence of input data, processing means clocked by a clock signal and having N outputs for producing per cycle of the clock signal N data respectively associated to N input data respectively stored in the N elementary source memories at relative source addresses,

N single port target memories,

N interleaving tables containing for each relative source address the number of one target memory and the corresponding relative target address therein, and,

N cells connected in a ring structure.

Each cell is further connected between one output of the processing means, one interleaving table, and the port of one target memory.

Each cell is adapted to receive data from said output of the processing means and from its two neighbouring cells, and to dispatch at least some of these received data to at least one of said two neighbouring cells or to write at least some of these received data sequentially in the associated target memory, in accordance with the contents of said interleaving tables.

In other words, the interconnect driven design approach according to the invention leads to simplified local interleaver cells with almost negligible control flow. No global routing nor global control is necessary.

According to an embodiment of the invention, each cell comprises

- distribution means connected to the corresponding output of the processing means, to the corresponding interleaving table and to the two neighbouring cells for receiving generated data respectively associated with target information containing the corresponding number of the target memory and the corresponding relative target address, and for delivering said generated data associated with their target information, together with corresponding direction information, and
- sorting buffer means connected to said distribution means, to the corresponding target memory and to the two neighbouring cells for receiving the corresponding data associated with their target information and their corresponding direction information, selecting from these data those which are to be actually passed through in accordance with the corresponding direction information, and delivering them sequentially.

According to an embodiment of the invention, said distribution means comprises

- a local distributor connected to the corresponding output of the processing means and to the corresponding interleaving table for receiving a generated local data associated with a target information, and for delivering said generated local data associated with its target information, together with a direction information,
- a right-in distributor for receiving a right-in data delivered by the right neighbouring cell associated with a target information, and for delivering said right-in data associated with its target information, together with a direction information,
- a left-in distributor for receiving a left-in data delivered by the left neighbouring cell associated with a target information, and for delivering said left-in data associated with its target information, together with a direction information.

According to an embodiment of the invention, said sorting buffer means comprises

- a local out sorting buffer having three inputs respectively connected to the local, right-in and left-in distributors, and one output connected to the port of the corresponding target memory, for receiving the corresponding data associated with their target information and their corresponding direction information, selecting from these data those which are to be stored in the target memory in accordance with the corresponding direction information, and for writing them sequentially in said target memory in accordance with their relative target addresses,
- a left out sorting buffer having two inputs respectively connected to the local and right-in distributors, and one output connected to right-in distributor of the left neighbouring cell, for receiving the corresponding data associated with their target information and their direction information, selecting from these data those which are to be delivered to said right in distributor of the left neighbouring cell in accordance with their direction information, and for delivering sequentially said selected data with their target information,
- a right out sorting buffer having two inputs respectively connected to the local and left-in distributors, and one output connected to the left-in distributor of the right neighbouring cell, for receiving the corresponding data associated with their target information and their direction information, selecting from these data those which are to be delivered to said left-in distributor of the right neighbouring cell in accordance with their direction information, and for delivering sequentially said selected data with their target information.

Each sorting buffer comprises advantageously

- sorting means associated with a reference direction information, having inputs forming the inputs of the sorting buffer, a number of outputs equal to the number of inputs, and control input means for receiving said direction information, said sorting means being adapted to select from the data received at its inputs those having a direction information identical with said reference direction information, and to deliver the selected data to consecutive outputs,
- register means comprising a predetermined number of elementary register, each elementary register being adapted to store a selected data with its target information,
- writing pointer means for writing the selected data in consecutive elementary registers before being shifted by the number of values actually written, and
- reading pointer means for reading sequentially the elementary registers.

The electronic device according to the invention may be realized by an integrated circuit.
The invention as claimed proposes also a code-decoder or a code-encoder comprising an electronic device as defined above.
This code decoder can be a turbo-code decoder.
The invention as claimed proposes also a component of a wireless communication system, comprising a code decoder as defined above.
Such a component can form a cellular mobile phone or a base station.
Other advantages and features of the invention will appear on examining the detailed description of embodiments, these being in no way limiting, and of the appended drawings in which :

- figure 1 shows a receiving chain of a cellular mobile phone including an electronic device according to the invention,
- figure 2 shows a turbo-decoder including an electronic device according to the invention,
- figure 3 is another diagrammatical representation of an electronic device according to the invention incorporated in a turbo-code decoder,
- figure 4 shows more in details a part of an electronic device according to the invention,
- figure 5 shows more in detail but still diagrammatically, a local cell incorporated in an electronic device according to the invention,
- figures 6 and 7 show more in details, but still diagrammatically sorting buffer incorporated in an electronic device according to the invention.

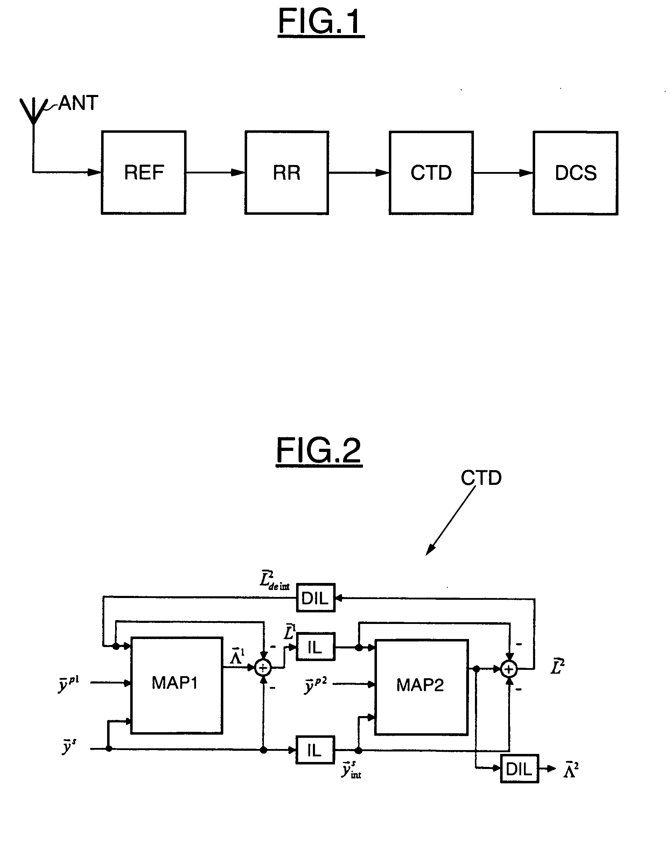

We refer now to figure 1 which illustrates a turbo-decoder according to the invention which is incorporated in the reception chain of a cellular mobile phone TP, although the invention is not limited to this particular application.
The encoded signal is being received by the antenna ANT and processed by the radio frequency stage ERF of the receiver. At the output of the ERF stage, the signal is converted into the digital domain by an A/D converter. The digital base band signal is then processed by a "rake" demodulator RR which is used generally in the case of a CDMA system.
Then, the channel decoding stage includes a Turbo-code decoder CTD according to the invention.
The processing chain comprises also a source decoding block DCS, which performs the source decoding treatments.
The third generation mobile radio system specifies Convolutional codes as well as Turbo-codes as channel coding techniques [3GPP, Technical Specification Group Radio Access Network *; Multiplexing and channel coding (FDD)* ; (3G TS 25.212 version 3.5.0(2000-12)), Release 1999].
In Turbo-code encoders forward error correction is enabled by introducing parity bits. For Turbo-codes, the original information, denoted as systematic information, is transmitted together with the parity information. The encoder for 3GPP consists of two recursive systematic convolutional (RSC) encoders with constraint length K=4, which can also be interpreted as 8-state finite state machines. The first RSC encoder works on the block of information in its original, the second one in an interleaved sequence.
On the receiver side, there is a corresponding component decoder for each of them. Each component decoder implements for example a so-called Maximum-A-Posteriori (MAP) Algorithm, and is usually so-called Soft-in-Soft-out (SISO) decoder .

Each block of information is decoded in an iterative manner. The systematic information and the parity information serve as inputs of the first component decoder (MAP1). The soft-output of MAP1 reflects its confidence on the received bits of being sent either as '0' or '1'. These confidences are interleaved in the same manner as in the encoder and passed to the second component decoder (MAP2) as a-priori information. The second component decoder uses this information to bias its estimation comprising the interleaved systematic information and the parity information of the second encoder. The soft-outputs are again passed on to MAP1, and so on. The exchange continues until a stop criterion is fulfilled. Stop criteria range from simple cases, such as "fixed number of iterations", over cyclic redundancy check (CRC) to rather complex statistical analysis.

Implementation issues for Turbo-decoder architectures using the MAP algorithm have already been discussed in several papers and are well known [A.Worm. *Implementation Issues of Turbo-Decoders.* Phd thesis, Institute of Microelectronic Systems, Departement of Electrical engineering and Information Technology, University of Kaiserslautern, Forschungsberichte Mikroelektronik, Bd.3, Germany, 2001].

The MAP algorithm is transformed into the logarithmic domain to reduce operator strength [S.S. Pietrobond and A.S. Barbulescu. A Simplification of the Modified Bahl Decoding Algorithm for Systematic Convolutional Codes. In *Proc. International Symposium on Information Theory and its Applications,* pages 1073-1077, Sydney, Australia, November 1994]: multiplications become additions, and additions are replaced by a modified comparison. It consists of a forward recursion, a backward recursion and soft-output calculation.

Decoding Turbo codes by searching the most likely codeword is far too complex. Therefore iterative decoding is advised. The two convolutional codes are decoded separately. While doing this, each decoder incorporates information that has been gathered by the other. This "gathering of information" is the exchange of soft-output values, where the bit-estimates of one unit are transformed into a priori information for the next. The decoders hence have to be soft-input soft-output (SISO) units.

The confidence in the bit estimation is represented as a Log-Likelihood-Ratio (LLR):

$$\Lambda(d_k) = \ln \frac{P(d_k = 1)}{P(d_k = 0)}$$

The sign shows whether this bit is supposed to be one or zero whereas the confidence in the decision is represented by the magnitude.

In order to extract the information that has been gathered during the last decoding stage, the systematic and a priori information that lead to this estimate have to be subtracted. This yields:

$$L^1(d_k) = \Lambda^1(d_k) - y_k^s - L_{deint}^2(d_k)$$

$$L^2(d_k) = \Lambda^2(d_k) - y_{kint}^s - L_{int}^1(d_k)$$

This is called the extrinsic information.

The confidence of one decoder in a bit to have a certain value biases the initial guess of the other.

Figure 2 shows such a Turbo code decoder CTD consisting of two MAP decoders, interleaving means IL and de-interleaving means DIL. Feeding the input of one decoder as a priori information input to the next enables the improvement over the decoding iterations. It also gave Turbo codes their name, as it resembles the "feedback-of-exhaust" used in combustion turbo engines. Inputs to the decoder are the received channel values (systematic, parity1 and parity2); during the very first MAP1 operation, the a priori information is set to zero.

In addition to the SISO decoders MAP1 and MAP2, memories are needed to store the input and output values, in particular for the interleaver and deinterleaver pattern.

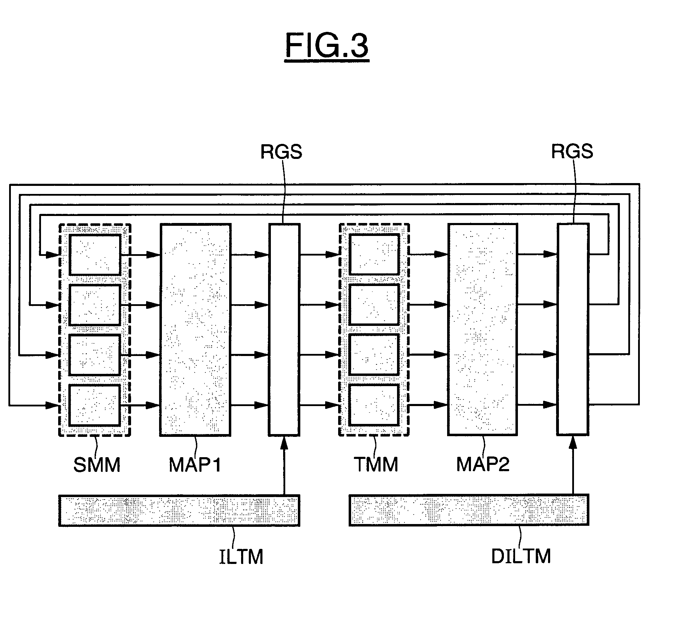

Figure 3 shows diagrammatically some of these memories.

More precisely, on this example, the MAP1 unit, as well as the MAP2 unit, is a multi-LLR producer which has N outputs (here : N = 4) for producing, per cycle of the clock signal which clocks the MAP unit, N data (here : N LLR) respectively associated to N input data respectively stored in N elementary source memories which form source memory means SMM.

N cells connected in a ring structure RGS are connected to the N output of the MAP1 unit as well as to interleaving table means constituted here by N interleaving tables. After having passed through the ring structure RGS, the N produced data (here, the N produced LLR) are stored in target memory means TMM constituted here by N target memories.

Each of the source memory and the target memory is a single port memory.

For the MAP2 unit, the target memory means TMM act as source memory means and the source memory means SMM of the MAP1 unit act as target memory means for the MAP2 unit. Further, the interleaving table means is replaced by deinterleaving table means DILTM.

Generally speaking, an electronic device according to the invention comprises processing means (here, the MAP1 unit, for example) source memory means SMM, the ring structure RGS, the interleaving table means ILTM, and the target memory means TMM.

The structure and the operation of such an electronic device will be now described more in details in reference to the following figures. Further, although the electronic device is described by using interleaving table means, it is clear that the same concept applies to deinterleaving table means which can be in fact considered as being also in a certain way interleaving table means.

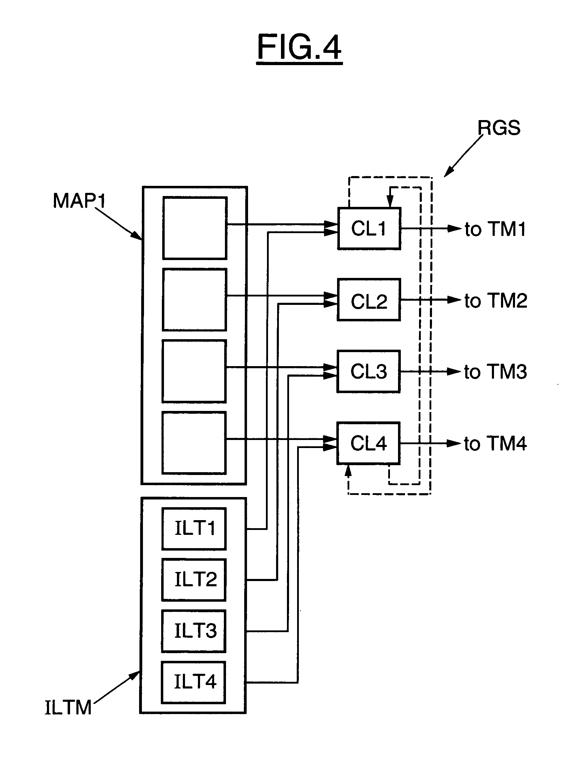

As illustrated more in details in figure 4, in which N is equal to 4, each cell CLi of the ring structure RGS, is connected between one output of the processing means MAP1, one interleaving table ILTi and the port of one target memory TMi.

Generally speaking, all the cells are adapted to receive data from the respective outputs of the processing means and from their two respective neighbouring cells, and to dispatch at least some of these received data to at least one of said two respective neighbouring cells or to write respectively at least some of these received data sequentially in the associated target memories, in accordance with the contents of said interleaving tables.

Each interleaver table ILTi comprises, for each relative source address of one source memory, the relative target address of a corresponding target memory as well as the number of this target memory. The number of the target memory and the corresponding relative target address therein constitute a target information associated to a data (LLR).

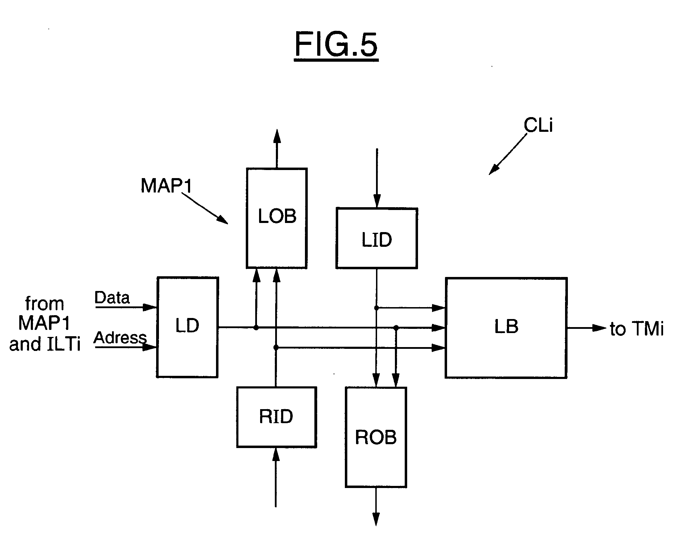

As illustrated more particularly in figure 5, a cell CLi comprises distribution means (LD) connected to a corresponding output of the processing means MAP1 and to the corresponding interleaving table, and also distribution means (RID, LID) connected to the two neighbouring cells.

The distribution means are adapted to receive generated data respectively associated with their target information. The distribution means will then deliver said generated data associated with their target information together with corresponding direction information.

Further to the distribution means, each cell comprises also sorting buffer means LB, LOB, ROB, connected to said distribution means, but also to the corresponding target memory and to the two neighbouring cells.

Generally speaking, sorting buffer means are adapted to receive the corresponding data associated with their target information and their corresponding direction information, to select from these data those which are to be actually passed through in accordance with the corresponding direction information, and delivering them sequentially.

Turning now again to the distribution means, it appears in figure 5 that the distribution means comprises a local distributor LD connected to the corresponding output of the processing means MAP1 and to the corresponding interleaving table. The local distributor receives a generated local data associated with its target information containing the corresponding number of the target memory and the corresponding relative target address therein.

This local distributor LD of the cell CLi has only to decide whether the incoming data is stored in the target RAM TMi connected to the cell CLi, or has to be sent left or right. The direction for non-local data is determined based on the shortest path to the target RAM.

The local distributor, which is formed for example by a logic circuit, delivers the received data with its target information and generates a direction information for this data.

This direction information is for example a word of two bits. For example, the values (0,0) means "go ahead" to the target RAM TMi. The values (0,1) means "go left" whereas the values (1,0) means "go right".

A look-up table, not represented in figure 5, is associated with the cell and contains a mapping of the different values of the direction information and the numbers of the different cells (i.e. the numbers of the different target memories). When a data arrives, the local distributor LD compares the number of the corresponding target memory associated with this data with the content of the look-up table to generate a corresponding direction information.

Two additional distributors are necessary in each cell for the left and right inputs. More precisely, the distribution means of the cell CLi comprises a right-in distributor RID and a left-in distributor LID.

The right-in distributor is adapted to receive a right-in data delivered by the right neighbouring cell associated also with a target information. The right-in distributor delivers said right-in data associated with its target information, together with a direction information. The direction information is also generated using the look-up table.

By analogy, the left-in distributor LID is adapted to receive a left-in data delivered by the left neighbouring cell and for delivering said left-in data associated with its target information, together with a direction information.

As illustrated in figure 5, a data received by the local distributor LD can be stored in the local target memory TMi or be sent left or right.

By analogy, a data received by the right-in distributor can be stored to the local target RAM TMi or be sent to the left neighbouring cell.

A data received by the left-in distributor LID can be stored in the local RAM TMi or be sent to the right neighbouring cell.

The sorting buffer means comprises a local out sorting buffer LB having three inputs respectively connected to the local, right-in and left-in distributors. The local out sorting buffer LOB has also one output connected to the port of the local target memory TMi.

The local out sorting buffer LD is adapted to receive the corresponding data associated with their target information and their corresponding direction information, selecting from these data those which are to be stored in the target memory TMi in accordance with the corresponding direction information, and for writing them sequentially in said target memory in accordance with their relative destination addresses.

In the present case, the local out buffer LB can receive 0, 1 2 or 3 data in one clock cycle, to be stored in the local target RAM. In other words, as several data sets may have the same target, the local buffer must be capable of storing more than one data per cycle and to deliver them sequentially one data per cycle. A specific architecture for such a buffer will be described more in details thereafter.

The left out sorting buffer LOB is adapted to receive the corresponding data associated with their target information and their direction information, to select for these data those which are to be delivered to said right-in distributor of the left neighbouring cell in accordance with their direction information, and for delivering sequentially said selected data with their target information.

By analogy, the sorting buffer means comprises also a right-out sorting buffer ROB having two inputs respectively connected to the local and left-in distributor of the right neighbouring cell. The right out sorting buffer ROB is adapted to receive the corresponding data associated with their target information and their direction information, selecting from these data those which are to be delivered to said left-in distributor of the right neighbouring cell in accordance with their direction information, and to deliver sequentially said selected data with their target information.

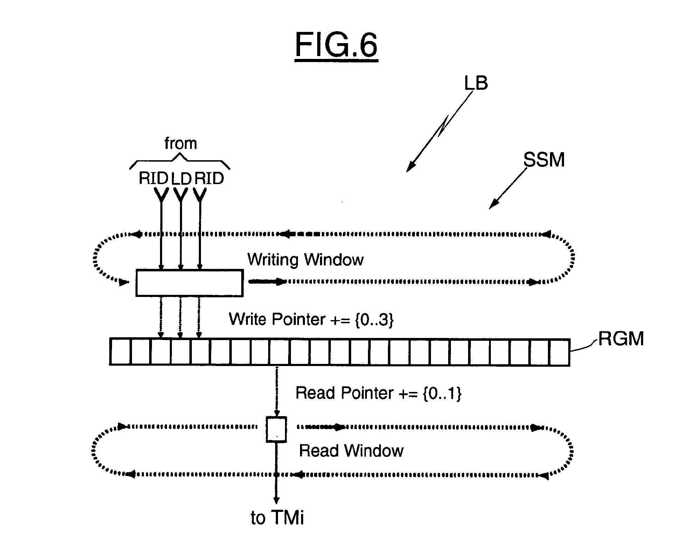

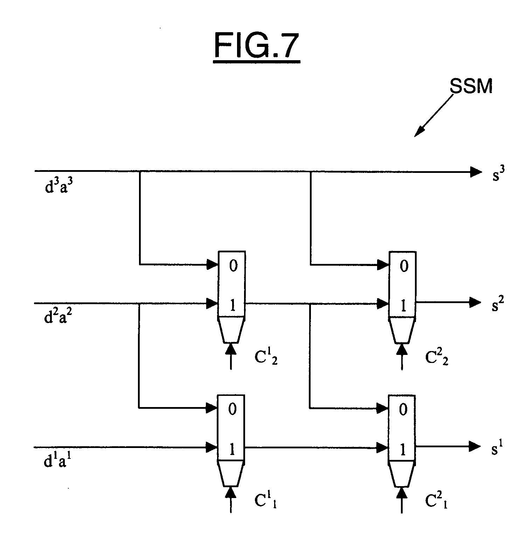

We refer now to figures 6 and 7 to describe more in details one embodiment of the local out buffer LB.

As already explained, three data are received on the three inputs of the local out buffer LB. However, none of those or some of those or all the three data have to be stored in the local target RAM TMi, depending on their direction information.

And, all these three data are received in the same clock cycle. However, only one data can be stored per cycle in the target RAM TMi.

Thus, such a buffer must be able to store three values and output one value to memory in the same cycle.

Such a buffer does not need to support random access. It is implemented as special registered files capable of storing up to three values in parallel. A value is composed here of a LLR-data with its associated target information, including the associated relative address.

Write and read accesses to a buffer can be modeled with writing windows where values can be stored in registers and reading windows. The writing window contains three registers, the worst case number of concurrent write accesses. Shifting it only by the number of values actually written prevents the creation of "holes" with irrelevant values.

Figure 7 illustrates diagrammatically one embodiment of the sorting means SMM buffer. The sorting means comprises here two stages of two multiplexers 2 : 1 controlled by control signals $C_j^k$.

When a control signal takes the value 1, the data which is received at the input 1 of the multiplexer is delivered at the output. By analogy, when a control signal takes the value 0, the data which is received at the input 0 is delivered at the output of the multiplexer.

The sorting means SSM are associated with a referenced direction information for this buffer, for example the referenced direction information (0,0) for the local out sorting buffer LB. When a data arrives at the input of the sorting means SSM, its direction information is compared with the referenced direction information. If these two direction information are identical, a decision variable $r^x$ is associated with the data and takes the value 1, for example. In the contrary, the decision variable $r^x$ takes the value 0.

Control means, realized by logic gates, generates then the control signals as mentioned thereafter :

$$C^1{}_1 = r^1$$
$$C^1{}_2 = r^1$$
$$C^2{}_1 = r^2 \text{ or } r^1$$
$$C^2{}_2 = r^2$$

Thus, from the inputs, only those which are relevant for this buffer are selected and aligned such that they form an uninterrupted sequence starting from $s^1$ for example. These sorted sequence and the total number of relevant inputs (R) is passed to the register means. The output $s^1$ to $s^R$ are stored in the register means RGM. This ensures a continuous filling of the register's means RGM of relevant data only.

When reading from the register means RGM, the local address a and the data $\underline{d}$ are separated again and used to address the local target RAM accordingly.

Of course, an analogous architecture is used for the left out sorting buffer and the right out sorting buffer, with the differences that they have only two inputs instead of three.

A parametrisable VHDL model of the electronic device according to the invention has been developed. Synthesis was carried out using a 0,20μm standard cell library. Under worst case conditions, a maximum clock frequency of 190 MHz is achieved, whereas state of the art implementations of constituent MAP decoders in this technology can be clocked at about 150 MHz.

A Turbo-decoder system with 16 producers featuring a distributed architecture according to the invention can be clocked at 150 MHz. Comparing on a throughput basis, one would need 26 producers at 90 MHz using a tree-like structure as presented in ISCAS'02 (May 02), leading to a total area increase of about 30%.

The invention is not limited to the particular application of channel decoding using turbo code but applies also to LDPC code decoders whose parity check matrix can also be interpreted as multiple interleavers.

Further the architecture according to the invention is not only useful for wireless systems but for all kinds of communication systems including wireline, wireless, router ...

The architecture according to the invention can be used for all kinds of interleaver and de-interleaver like Turbo-code interleaver/de-interleaver or normal channel interleaver or de-interleaver.

More generally, the invention relates to the storage of multiple data produced during one clock cycle, into memories which have a number of ports smaller than the number of data which are to be stored simultaneously in those memories.

And the architecture according to the invention can be used for all kind of systems with multiple sources and multiple sinks with a statistically equal access distribution. An equal distribution of the access to the sink leads to an optimum implementation.

For non equally distributed systems the architecture is no longer optimum but sub-optimum. Nevertheless, it can still be used with some additional amount of memory.

**Claims**

1. Electronic device, comprising a source memory means (SMM) partitioned in N elementary source memories for storing a sequence of input data, processing means (MAP1) clocked by a clock signal and having N outputs for producing per cycle of the clock signal N data respectively associated to N input data respectively stored in the N elementary source memories at relative source addresses, N single port target memories (TMi), N interleaving tables (ILTi) containing for each relative source address the number of one target memory and the corresponding relative target address therein, N cells (CLi) connected in a ring structure, each cell being further connected between one output of the processing means, one interleaving table, and the port of one target memory, each cell being adapted to receive data from said output of the processing means and from its two neighbouring cells, and to dispatch at least some of these received data to at least one of said two neighbouring cells or to write at least some of these received data sequentially in the associated target memory, in accordance with the contents of said interleaving tables.

2. Electronic device according to claim 1, **characterized by** the fact that each cell comprises

   - distribution means (LD, RID, LID) connected to the corresponding output of the processing means, to the corresponding interleaving table and to the two neighbouring cells for receiving generated data respectively associated with target information containing the corresponding number of the target memory and the corresponding relative target address, and for delivering said generated data associated with their target information, together with corresponding direction information, and
   - sorting buffer means (LB, LOB, ROB) connected to said distribution means, to the corresponding target memory and to the two neighbouring cells for receiving the corresponding data associated with their target information and their corresponding direction information, selecting from these data those which are to be actually passed through in accordance with the corresponding direction information, and delivering them sequentially .

3. Electronic device according to claim 2, **characterized by** the fact that said distribution means comprises

   - a local distributor (LD) connected to the corresponding output of the processing means and to the corresponding interleaving table for receiving a generated local data associated with a target information, and for delivering said generated local data associated with its target information, together with a direction information,
   - a right-in distributor (RID) for receiving a right-in data delivered by the right neighbouring cell associated with a target information, and for delivering said right-in data associated with its target information, together with a direction information,

- a left-in distributor (LID) for receiving a left-in data delivered by the left neighbouring cell associated with a target information, and for delivering said left-in data associated with its target information, together with a direction information.

4. Electronic device according to claim 3, **characterized by** the fact that said sorting buffer means comprises

- a local out sorting buffer (LB) having three inputs respectively connected to the local, right-in and left-in distributors, and one output connected to the port of the corresponding target memory, for receiving the corresponding data associated with their target information and their corresponding direction information, selecting from these data those which are to be stored in the target memory in accordance with the corresponding direction information, and for writing them sequentially in said target memory in accordance with their relative target addresses,
- a left out sorting buffer (LOB) having two inputs respectively connected to the local and right-in distributors, and one output connected to the right-in distributor of the left neighbouring cell, for receiving the corresponding data associated with their target information and their direction information, selecting from these data those which are to be delivered to said right-in distributor of the left neighbouring cell in accordance with their direction information, and for delivering sequentially said selected data with their target information,
- a right out sorting buffer (ROB) having two inputs respectively connected to the local and left-in distributors, and one output connected to the left-in distributor of the right neighbouring cell, for receiving the corresponding data associated with their target information and their direction information, selecting from these data those which are to be delivered to said left-in distributor of the right neighbouring cell in accordance with their direction information, and for delivering sequentially said selected data with their target information.

5. Electronic device according to any one of claims 2 to 4, **characterized by** the fact that each sorting buffer comprises

- sorting means (SMM) associated with a reference direction information, having inputs forming the inputs of the sorting buffer, a number of outputs equal to the number of inputs, and control input means for receiving said direction information, said sorting means being adapted to select from the data received at its inputs those having a direction information identical with said reference direction information, and to deliver the selected data to consecutive outputs,
- register means (RGM) comprising a predetermined number of elementary registers, each elementary register being adapted to store a selected data with its target information,
- writing pointer means for writing the selected data in consecutive elementary registers before being shifted by the number of values actually written, and
- reading pointer means for reading sequentially the elementary registers.

6. Electronic device according to any one of the preceding claims, **characterized by** the fact that it is realized by an integrated circuit.

7. Code decoder, **characterized by** the fact that it comprises an electronic device according any one of the preceding claims.

8. Code decoder according to claim 7, **characterized by** the fact that it is a Turbo-code decoder.

9. Code encoder, **characterized by** the fact that it comprises an electronic device according any one of the preceding claims.

10. Code encoder according to claim 9, **characterized by** the fact that it is a Turbo-code encoder.

11. Interleaver, **characterized by** the fact that it comprises an electronic device according any one of claims 1 to 6.

12. De-interleaver, **characterized by** the fact that it comprises an electronic device according any one of claims 1 to 6.

13. Component of a communication system, for example a wireless communication system, **characterized by** the fact that it comprises a Code decoder according to claim 7 or 8.

14. Component according to claim 13, **characterized by** the fact that it comprises a Code encoder according to claim 9 or 10.

**15.** Component according to claim 14, **characterized by** the fact that it forms a cellular mobile phone.

**16.** Component according to claim 14, **characterized by** the fact that it forms a base station.

# FIG.1

# FIG.2

# FIG.3

RGS

RGS

SMM    MAP1    TMM    MAP2

ILTM    DILTM

# FIG.4

MAP1

RGS

ILTM

ILT1
ILT2
ILT3
ILT4

CL1 → to TM1
CL2 → to TM2
CL3 → to TM3
CL4 → to TM4

# FIG.5

CLi

MAP1

LOB

LID

from
MAP1
and ILTi

Data

Adress

LD

LB

to TMi

RID

ROB

# FIG.6

LB

SSM

from

RID LD RID

Writing Window

Write Pointer += {0..3}

RGM

Read Pointer += {0..1}

Read Window

to TMi

# FIG.7

EP 1 401 108 A1

**European Patent Office**

**EUROPEAN SEARCH REPORT**

Application Number

EP 02 29 2244

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | THUL M J ET AL: "Enabling high-speed turbo-decoding through concurrent interleaving" 2002 IEEE INTERNATIONAL SYMPOSIUM ON CIRCUITS AND SYSTEMS. PROCEEDINGS (CAT. NO.02CH37353), 22002 IEEE INTERNATIONAL SYMPOSIUM ON CIRCUITS AND SYSTEMS, PHOENIX-SCOTTSDALE, AZ, USA, 26-29 MAY 2002, pages I-897-900 vol.1, XP002229238 2002, Piscataway, NJ, USA, IEEE, USA ISBN: 0-7803-7448-7 * page 897, column 1, line 1 - page 900, column 2, last line; figure 2 * | 1 | H03M13/29 H04L1/00 |
| D,A | GIULIETTI A ET AL: "Parallel turbo coding interleavers: avoiding collisions in accesses to storage elements" ELECTRONICS LETTERS, 28 FEB. 2002, IEE, UK, vol. 38, no. 5, pages 232-234, XP002229239 ISSN: 0013-5194 * page 232, column 2, line 7 - page 234, column 1, line 15; figures 1,2 * | 1 | |

TECHNICAL FIELDS SEARCHED (Int.Cl.7)

H03M
H04L

-/--

The present search report has been drawn up for all claims

| Place of search | Date of completion of the search | Examiner |
|---|---|---|
| THE HAGUE | 29 January 2003 | Van Staveren, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

18

**European Patent Office**

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | GIULIETTI A ET AL: "A 80 Mb/s low-power scalable turbo codec core" PROCEEDINGS OF THE IEEE 2002 CUSTOM INTEGRATED CIRCUITS CONFERENCE (CAT. NO.02CH37285), PROCEEDINGS OF THE IEEE 2002 CUSTOM INTEGRATED CIRCUITS CONFERENCE, ORLANDO, FL, USA, 12-15 MAY 2002, pages 389-392, XP002229240 2002, Piscataway, NJ, USA, IEEE, USA ISBN: 0-7803-7250-6 * page 389, column 1, line 1 - page 392, column 2, last line * * page 390, column 2, line 31 - page 391, column 1, line 37; figure 2 * --- | 1 | |
| D,A | 3GPP: "3rd Generation Partnership Project; Technical Specification Group Radio Access Network; Multiplexing and channel coding (FDD) (Release 1999)" 3GPP TS 25.212 V3.5.0 , 2000, pages 1-62, XP002229241 * paragraph [4.2.3.2] * --- | 1 | |
| D,A | "A Simplification of the Modified Bahl Decoding Algorithm for Systematic Convolutional Codes" PROC. INTERNATIONAL SYMPOSIUM ON INFORMATION THEORY AND ITS APPLICATIONS, [Online] November 1994 (1994-11), pages 1-5, XP002229242 Sydney, Au Retrieved from the Internet: <URL:http://citeseer.nj.nec.com/pietrobon94simplification.html> [retrieved on 2003-01-29] * page 1, column 1, line 1 - page 5, column 2, last line; figure 4 * ----- | 1 | TECHNICAL FIELDS SEARCHED (Int.Cl.7) |

The present search report has been drawn up for all claims

| Place of search | Date of completion of the search | Examiner |
|---|---|---|
| THE HAGUE | 29 January 2003 | Van Staveren, M |

EPO FORM 1503 03.82 (P04C01)